# FASCICULE DE BREVET EUROPEEN

(11) **EP 2 617 049 B1**
(45) Date de publication et mention de la délivrance du brevet: **10.10.2018**
(21) Numéro de dépôt: 11773106.7
(22) Date de dépôt: 16.09.2011
(51) Int. Cl.: H01J 37/073, H01J 37/28, H01J 1/304

(54) **CANON À ÉLECTRONS ÉMETTANT SOUS HAUTE TENSION, DESTINÉ NOTAMMENT À LA MICROSCOPIE ÉLECTRONIQUE**
ELEKTRONENKANONE, EMITTIEREND UNTER HOHER SPANNUNG, IM BESONDEREN FÜR ELEKTRONENMIKROSKOPIE
ELECTRON GUN EMITTING UNDER HIGH VOLTAGE, IN PARTICULAR FOR ELECTRON MICROSCOPY

(30) Priorité: 17.09.2010 FR 1003696
(43) Date de publication de la demande: 24.07.2013
(73) Titulaire: Centre National de la Recherche Scientifique (C.N.R.S.), 75016 Paris (FR)
(72) Inventeur: MONTHIOUX, Marc, F-31840 Aussonne (FR); HOUDELLIER, Florent, F-31000 Toulouse (FR)
(74) Mandataire: Bréda, Jean-Marc
(86) Numéro de dépôt international: PCT/FR2011/052135
(87) Numéro de publication internationale: WO 2012/035277

(56) Documents cités:
- US-A1- 2006 231 773
- US-A1- 2007 102 650
- US-A1- 2008 029 700
- US-A1- 2008 067 407
- US-A1- 2008 287 030
- US-B2- 6 930 313

## Description

La présente invention concerne un canon à électrons émettant sous haute tension et destiné notamment à la microscopie électronique.

Le principe de la microscopie électronique est d'utiliser un faisceau d'électrons à la place du faisceau de lumière utilisé en microscopie optique. La longueur d'onde associée au faisceau d'électrons permet d'obtenir une résolution en microscopie électronique nettement supérieure à celle obtenue en microscopie optique. Toutefois, des contraintes sont liées à l'utilisation des électrons. Il convient notamment d'avoir un vide poussé à l'intérieur du microscope. Un faisceau d'électrons est alors focalisé sur l'échantillon à observer par l'intermédiaire de lentilles électromagnétiques. Dans le cas de la microscopie électronique en transmission (différente de la microscopie électronique à balayage) les échantillons utilisés doivent être ultraminces afin d'être aussi transparents que possible aux électrons et on n'analyse que les électrons qui traversent l'échantillon. On distingue alors trois types d'électrons : les électrons transmis qui n'ont pas interagi avec l'échantillon, les électrons diffusés sans perte d'énergie suite à une interaction avec les atomes de l'échantillon et les électrons diffusés avec perte d'énergie suite à l'interaction des électrons incidents avec des cortèges électroniques des atomes de l'échantillon. L'analyse des faisceaux d'électrons transmis et des faisceaux d'électrons diffusés permet de créer le contraste des images obtenues en microscopie électronique en transmission (appelée également MET).

La présente invention concerne un microscope permettant la mise en oeuvre du principe de microscopie électronique notamment en transmission et plus particulièrement un canon à électrons utilisé dans un tel microscope, c'est-à-dire le dispositif permettant d'émettre un faisceau d'électrons sur un échantillon à observer. L'invention concerne également d'autres appareillages de visualisation ou de traitement mettant en jeu une, ou plusieurs, source d'électrons comme par exemple un microscope électronique à balayage, un dispositif de nanogravure de type FIB (Focused Ion Beam soit en français faisceau d'ions focalisés), ou un dispositif de nanolithographie électronique.

Il y a deux principales familles de canon à électrons. On distingue les canons à électrons à cathode chaude et les canons à électrons à cathode froide.

Les canons à électrons à cathode chaude utilisent l'effet Joule pour extraire des électrons d'un filament, généralement un filament de tungstène ou d'hexaborure de lanthane. Dans cette famille, les canons à émission thermoïonique présentent une pointe de métal en forme de V qui est chauffée à haute température. De ce fait, les électrons présents dans le métal se déplacent à grande vitesse. Les électrons arrivant à la pointe du V sont alors éjectés du métal. Une différence de potentiel importante est appliquée afin d'accélérer les électrons sortis du métal. Ces électrons sont attirés vers l'anode en direction de l'échantillon à observer.

Un inconvénient de ce type de canon à électrons est le manque de cohérence spatiale et temporelle du faisceau d'électrons obtenu. Concernant la cohérence temporelle, l'énergie cinétique, et donc la vitesse, des électrons émis est répartie selon une distribution gaussienne. On observe une aberration chromatique plus importante pour les filaments en tungstène que pour les filaments en hexaborure de lanthane qui sont toutefois beaucoup plus chers. La cohérence spatiale quant à elle reste très limitée en raison de l'étendue importante de la surface d'émission des électrons en bout de filament.

Une autre famille de canons à électrons sont les canons à émission de champ, appelés également canons à cathode froide, tels ceux décrits par US2008/029700 et US2008/0287030. Dans cette famille de canons à électrons, des électrons sont arrachés par effet tunnel à une fine pointe métallique, généralement en tungstène, ladite pointe métallique étant soumise à un champ électrique élevé (différence de potentiel de l'ordre de 2 à 7 kV).

De manière générale, une telle source d'électrons (à cathode froide) présente une faible variabilité énergétique et donc une bien meilleure cohérence temporelle que les sources d'électrons à cathode chaude. En outre, une source à émission de champ est quasiment ponctuelle ce qui améliore considérablement la cohérence spatiale. Elle présente alors une brillance bien plus élevée que les sources à cathode chaude. Cependant, ces sources à cathode froide nécessitent un vide extrêmement poussé. Sans la présence de ce vide, la pointe du canon s'oxyde et l'effet d'émission s'atténue.

Il existe également des variantes de canons à électrons. Ainsi, on peut citer les canons à émission de champ thermo-assistés. Il existe également des canons à effet de champ dit canons Schottky. Un tel canon possède une pointe plus large qui présente en surface une couche de zircone (ZrO₂). Le zircone possède un travail de sortie des électrons plus faible que le tungstène (ce qui augmente l'émission des électrons) et ainsi permet d'utiliser une pointe plus large. Ce dernier type de canon permet d'obtenir une bonne brillance.

Quelle que soit la nature de la source d'électrons, ceux-ci une fois extraits de la source sont ensuite accélérés par une tension appliquée entre la cathode et une anode accélératrice. Dans les microscopes électroniques par balayage, cette tension est de l'ordre de 1 à 30 kV. Dans les microscopes électroniques en transmission, cette tension peut atteindre 300 kV ou plus.

Dans le domaine de l'holographie électronique, et notamment l'holographie en champ sombre, des performances en termes notamment d'intensité, de brillance et de cohérence sont nécessaires. Les sources d'électrons décrites ci-dessus ont des performances limitées. La présente invention a alors pour but de fournir une source d'électrons fournissant un faisceau à la fois intense, brillant et surtout cohérent de manière à permettre d'améliorer la résolution et le champ des images holographiques.

Le problème technique est ainsi d'obtenir, dans des conditions sévères, un canon à électrons pour la microscopie électronique travaillant dans l'ultravide, en continu, sous très haute tension tout en permettant d'obtenir de préférence à la fois une forte brillance, une haute intensité, une faible dispersion énergétique, une grande cohérence spatiale avec des caractéristiques stables et durables.

À cet effet, la présente invention propose un canon à électrons à émission de champ comportant une pointe d'émission d'électrons supportée, une anode extractrice, ainsi que des moyens permettant de créer une différence de potentiel électrique entre la pointe d'émission et l'anode extractrice.

Selon la présente invention, la pointe d'émission comporte une seule pointe-support conductrice, par exemple une pointe métallique, et un unique cône d'extrémité obtenu par dépôt chimique en phase vapeur sur un nanofilament, le cône étant aligné et soudé sur la pointe-support conductrice.

Une telle structure permet principalement d'obtenir une excellente cohérence spatiale d'un faisceau d'électrons. Les dimensions de l'extrémité de la pointe peuvent être très sensiblement réduites par rapport aux extrémités de pointes d'émission des canons de l'art antérieur.

Dans un canon à électrons selon la présente invention, le cône d'extrémité utilisé permet d'obtenir de bonnes performances s'il s'agit d'un cône dont la matière est choisie dans l'ensemble des matériaux comprenant le carbone et les matériaux décrits ou représentés par la formule CₓB_{y}N_{z}, C correspondant au carbone, B au bore et N à l'azote. Le nanofilament est quant à lui par exemple un nanofilament dont la matière est choisie dans l'ensemble des matériaux comprenant le carbone, les matériaux décrits ou représentés par la formule CₓB_{y}N_{z}, C correspondant au carbone, B au bore et N à l'azote, et les matériaux décrits ou représentés par la formule SiₓO_{y}, Si correspondant au silicium et O à l'oxygène. Toutefois, il est également envisageable d'avoir un nanofilament réalisé dans un matériau différent, dans la mesure où ce matériau est compatible avec un procédé de dépôt chimique en phase vapeur.

Pour obtenir de bonnes performances, le nanofilament est avantageusement un nanotube en carbone dont le diamètre est inférieur à 20 nm, de préférence inférieur à 10 nm (1 nm=10⁻⁹m). Le diamètre du tube correspond au diamètre de l'extrémité, ou apex, de la pointe émettrice, ici de l'extrémité du cône en carbone (ou autre matière).

Dans le canon à électrons selon l'invention, on peut prévoir que la pointe-support conductrice est en tungstène car il est possible de réaliser une bonne soudure entre le tungstène et le carbone. On peut également prévoir que le support de la pointe soit un filament métallique, par exemple en tungstène. Le support pourrait aussi être formé par deux microélectrodes ou un autre dispositif de support.

Le cône d'extrémité utilisé dans un canon à électrons selon la présente invention a par exemple une longueur comprise entre 0,5 et 10 µm (1 µm = 10⁻⁶ m).

Comme déjà mentionné plus haut en préambule, les canons à électrons à émission de champ, ou à cathode froide, nécessitent de réaliser un vide extrêmement poussé. Il est ici avantageux d'utiliser par exemple une pompe à getter non évaporable (appelée couramment pompe NEG de l'acronyme anglais : Non-Evaporable Getter) pour réaliser le vide dans une enceinte dans laquelle se trouve la pointe d'émission et l'anode extractrice.

La présente invention concerne également un microscope électronique en transmission comportant un canon à électrons ainsi qu'une colonne contenant divers éléments tels des composants d'optique électronique et des moyens d'accélération des électrons émis par le canon à électrons, caractérisé en ce que le canon à électrons est un canon à électrons tel que décrit ci-dessus.

La présente invention concerne également tout autre dispositif comportant un canon à électrons tel que décrit ci-dessus, notamment un microscope électronique par balayage ou un dispositif de gravure comportant un tel canon ou un dispositif d'irradiation électronique localisée, tel notamment un dispositif de nanogravure ou de nanolithographie muni d'un tel canon.

Les moyens d'accélération d'un microscope selon la présente invention peuvent comporter des moyens permettant de créer une différence de potentiel électrique de 200 kV ou plus. Bien entendu, les différences de potentiels moindres sont aussi envisageables.

Des détails et avantages de la présente invention ressortiront mieux de la description qui suit, faite en référence aux dessins schématiques annexés sur lesquels :
La figure 1 est un diagramme illustrant la stabilité dans le temps d'un faisceau d'électrons obtenu avec un canon à électrons selon la présente invention,
La figure 2 illustre la différence de cohérence spatiale d'un faisceau d'électrons obtenu avec un canon à électrons selon la présente invention et un canon du même type mais avec une pointe de tungstène classique,
La figure 3 est un schéma d'un canon selon la présente invention avec un agrandissement montrant un cône utilisé dans un tel canon, et
La figure 4 montre partiellement en perspective et en coupe une forme de réalisation d'un canon selon la présente invention avec trois photos illustrant la liaison entre un filament et une pointe-support, l'extrémité libre de la pointe-support et une liaison entre l'extrémité de la pointe-support avec un cône de carbone.

La présente invention concerne plus particulièrement la microscopie électronique, notamment en transmission ou par balayage. Dans ce domaine, la présente invention propose un nouveau canon à électrons permettant d'obtenir des performances très intéressantes pour un microscope électronique utilisant un tel canon à électrons. De ce fait, la présente invention trouve des applications par exemple dans le domaine de la spectroscopie, l'holographie et l'holographie en champ sombre. Elle concerne également le domaine de la nanogravure.

Un canon à électrons selon la présente invention est du type canon à émission de champ ou canon FEG (de l'acronyme anglais Field Emission Gun). Dans un tel canon, les électrons sont extraits d'un filament métallique, par exemple en tungstène, par une force d'extraction d'un champ électrique existant entre le filament et une anode. On utilise ici le principe de l'émission de champ, appelé également effet tunnel. L'extraction d'électrons se fait sous vide. La tension d'extraction est généralement comprise entre 2000 et 7000 V (soit entre 2 et 7 kV).

La présente invention est de préférence utilisée dans un canon à émission de champ à cathode froide. Dans ce cas, le filament n'est pas chauffé et l'émission d'électrons est une émission de champ pure.

L'invention propose ici d'utiliser une structure connue de canon à émission de champ FEG à cathode froide en modifiant la pointe d'émission du filament en tungstène. Alors que la pointe d'émission d'un canon à électrons de l'art antérieur est généralement réalisé en tungstène, il est proposé ici d'utiliser, dans un mode de réalisation préféré de la présente invention, un cône de carbone sur nanotube.

L'extrémité d'une pointe d'émission est idéalement formée d'un seul atome. Toutefois, on ne sait pas réaliser une telle pointe. Les pointes en tungstène connues présentent généralement un apex, c'est-à-dire la zone la plus distale de la pointe, qui présente des dimensions de l'ordre de 50 à 100 nm (1 nm = 10⁻⁹m).

La présente invention propose quant à elle d'utiliser un cône pour l'émission des électrons dont l'apex présente un diamètre de l'ordre du nanomètre.

Il est déjà connu d'utiliser une technique de dépôt chimique en phase vapeur appelée aussi "à temps de vol" pour réaliser des cônes de carbone et supportés par des nanofilaments de carbone.

Toutefois, on peut envisager d'avoir des nanofilaments d'une nature autre que carbonée. Ils peuvent par exemple être à base de silicium. On peut également envisager des nanofilaments dopés au bore (système CₓB_{y}), ou bien encore des nanofilaments carbonés dopés à l'azote (système CₓN_{y}), ou plus généralement des nanofilaments appartenant au système CₓB_{y}N_{z}.

De même pour les cônes, on peut envisager des cônes en carbone comme indiqué ci-dessus mais également des cônes en carbone dopés au bore (système CₓB_{y}), ou bien encore des cônes carbonés dopés à l'azote (système CₓN_{y}), ou plus généralement des cônes appartenant au système CₓB_{y}N_{z}.

La synthèse des cônes en carbone est connue de l'homme du métier. Elle est résumée ci-après. Le principe de fabrication de tels cônes consiste à utiliser des nanofilaments comme substrat de dépôt et à utiliser un procédé de dépôt chimique en phase vapeur. Les nanofilaments sont des filaments ou nanotubes dont le diamètre est de l'ordre du nanomètre. Le procédé de dépôt chimique en phase vapeur utilise un four tubulaire de type piston qui dispose d'une zone de craquage-dépôt très étendue. Le document "chemical vapour déposition of pyrolytic carbon on carbon nanotubes" (Carbon 41, 2897-2912) aux noms de Allouche, Monthioux et Jacobsen décrit la morphologie de tels cônes sur nanofilaments ainsi qu'un procédé de synthèse de tels cônes. Il est proposé ici d'utiliser de tels cônes pour fournir un nouveau type de canon à électrons pour la microscopie électronique.

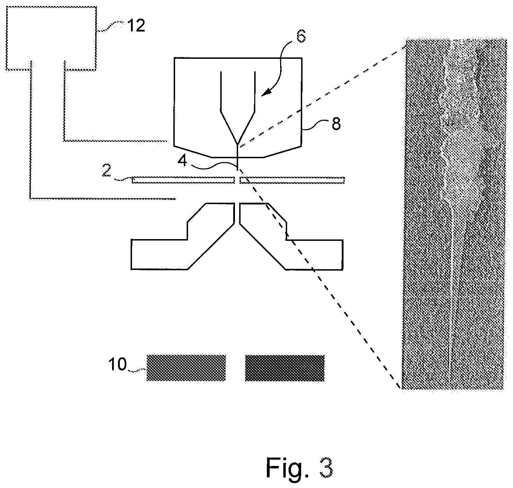

Comme illustré sur la figure 3, la structure générale d'un tel canon est celle d'un canon FEG à cathode froide. Il comporte notamment une anode extractrice 2 portée à un potentiel positif permettant d'extraire des électrons d'une pointe 4 par émission de champ pure. Comme on peut le voir sur la figure 3, la pointe 4, dite également pointe émettrice, est montée à l'extrémité d'un filament 6 présentant une forme en V et disposé à l'intérieur d'un suppresseur 8. La présence d'un tel suppresseur n'est pas obligatoire et on ne sortirait pas du cadre de la présente invention en supprimant celui-ci.

L'utilisation d'un cône supporté sur nanofilament tel que décrit ci-dessus est ici prévue comme pointe émettrice d'électrons. Un tel cône peut être facilement manipulé car il présente une base de taille micrométrique. Il peut être ainsi positionné et fixé par sa base à l'extrémité d'un filament de tungstène classiquement utilisé dans un canon FEG froid. L'extrémité d'un tel cône, ou apex, a un diamètre correspondant à celui du nanotube qui le supporte. On trouve donc ici un apex dont la taille est de l'ordre du nanomètre, c'est-à-dire comprise entre 0,2 et 10 nm par exemple. On a donc ici une pointe bien plus petite que celle de l'art antérieur en tungstène. L'apex du cône peut être l'apex du nanotube supportant le cône, si celui-ci est encore présent et dépasse le bout du cône.

Les propriétés des nanotubes de carbone, en ce qui concerne notamment la tenue en courant, la résistance mécanique et thermique, ..., permettent de réaliser un faisceau d'électrons extrêmement brillant dont la cohérence spatiale et temporelle permet de franchir un pas technologique dans le domaine de la microscopie électronique en transmission.

De manière bien connue dans le domaine des canons FEG, le canon représenté sur la figure 3 comporte d'une part un ensemble pointe/extracteur comprenant notamment la pointe 4 et l'anode extractrice 2. Ce premier bloc fournit des électrons puis les focalise. Ensuite, une anode accélératrice 10 accélère les électrons apportés par le premier bloc. Le canon fonctionne donc selon un procédé en deux étapes. La première étape d'extraction des électrons est la plus importante puisqu'elle définit les propriétés du faisceau utilisé. L'invention concerne cette partie du canon. La seconde étape, d'accélération, n'est pas concernée par l'invention. Le principe de fonctionnement au niveau de l'extraction, même si la structure du premier bloc du canon selon l'invention est distincte d'un premier bloc de canon à électrons FEG froid de l'art antérieur, fonctionne selon le même principe.

Au niveau de l'extraction, les électrons présents dans la pointe s'accumulent jusqu'à l'énergie de Fermi E_{F} et doivent, pour sortir de la pointe, rejoindre le vide séparé par une barrière d'énergie Φ. Dans un canon selon la présente invention, une haute tension V positive, par exemple 3000 V, est appliquée à un endroit le plus proche possible de l'apex afin que le champ électrique F à cet apex soit le plus fort possible. Ce champ électrique F est proportionnel à la tension V. En raison de la présence du champ électrique, le potentiel dans le vide peut être modélisé par une pente négative d'autant plus importante que la tension d'extraction est élevée. Les électrons présents au niveau de Fermi peuvent ainsi sortir dans le vide en traversant la barrière de potentiel par effet tunnel si la barrière est suffisamment réduite par l'effet de champ électrique. De manière logique, plus la tension d'extraction V sera importante et plus le courant d'émission sera fort. En utilisant à l'extrémité de la pointe émettrice un cône tel que décrit ci-dessus, notamment un cône en carbone, la taille de la zone émettrice est grandement diminuée et permet ainsi d'augmenter la valeur du champ électrique F à l'apex provenant de la tension positive V appliquée sur l'anode extractrice. Le facteur de champ (correspondant au quotient F/V) est ici bien supérieur au facteur de champ des pointes connues de l'art antérieur.

Pour réaliser une cathode dans un canon à électrons selon la présente invention, une pointe conductrice, en tungstène notamment, est microsoudée sur un filament réalisé dans le même matériau en forme de V. Le tungstène utilisé est par exemple un tungstène dont le cristal est orienté suivant l'axe de zone [310]. Toutefois, un autre métal, ou conducteur électrique, peut être envisagé pour réaliser la pointe. On peut utiliser ici un filament correspondant au filament utilisé comme source thermoélectronique. La pointe tungstène est ensuite amincie en utilisant un mélange de soude afin de réaliser une pointe dont l'apex est de l'ordre d'une centaine à quelques centaines de nanomètres.

Le filament ainsi traité, ainsi qu'un cône de carbone sont placés dans un instrument FIB (acronyme de l'anglais Focused Ion Beam ou en français faisceau d'ions focalisés) équipé d'un nanomanipulateur et d'un système GIS (Gaz Injection System). L'embase du cône est découpé par un faisceau d'ions puis est soudé au bout du filament en tungstène en veillant tout particulièrement à aligner la pointe dans l'axe du filament de tungstène. Le positionnement de l'embase du cône, qui a été préalablement découpée, avec la pointe de tungstène est réalisé grâce au nanomanipulateur. La soudure est quant à elle obtenue en utilisant l'effet combiné du faisceau d'ions et de l'injection de tungstène gazeux. La pointe, comportant la pointe en tungstène et le cône de carbone, est ensuite placée dans le premier bloc du canon à électrons au niveau duquel est réalisé l'extraction des électrons. Le vide est alors réalisé à l'intérieur du canon à électrons. On réalise ici un ultravide, par exemple un vide correspondant à une pression inférieure à 10⁻¹⁰ Torr (soit inférieure à environ 1,33 10⁻⁸ Pa).

Pour nettoyer la pointe de toutes ses impuretés en surface, il est proposé une étape d'étuvage de ladite pointe à des températures pouvant aller jusqu'à 600°C. Il est important de supprimer de telles impuretés qui causeraient des instabilités dans l'émission d'électrons.

Toutes ces étapes étant réalisées, le canon à électrons selon l'invention peut être placé au sommet d'une colonne d'un microscope électronique, notamment en transmission ou par balayage. On retrouve ici une structure de microscope classique dans laquelle des bobines déflectrices sont placées après le canon à électrons afin de compenser optiquement les mauvais alignements mécaniques forcément présents. Un tel canon à électrons pourrait également être utilisé au sein d'un dispositif de nanogravure, ou d'une manière générale dans tout dispositif requérant une irradiation très locale d'une cible par un faisceau d'électrons (par exemple : nanolithographie électronique).

Pour réaliser le vide à l'intérieur du canon à électrons, une pompe 12 est utilisée. Selon une forme de réalisation préférée, il s'agit d'une pompe de type NEG, c'est-à-dire une pompe à getter non évaporable pour permettre de réaliser un vide très poussé. Ce type de pompe utilise un piège à gaz qui agit par chimisorption ou par adsorption. La matière utilisée pour réaliser ce piège à gaz est appelé getter et est par exemple fabriquée à partir d'alliages à base de zirconium ou de titane.

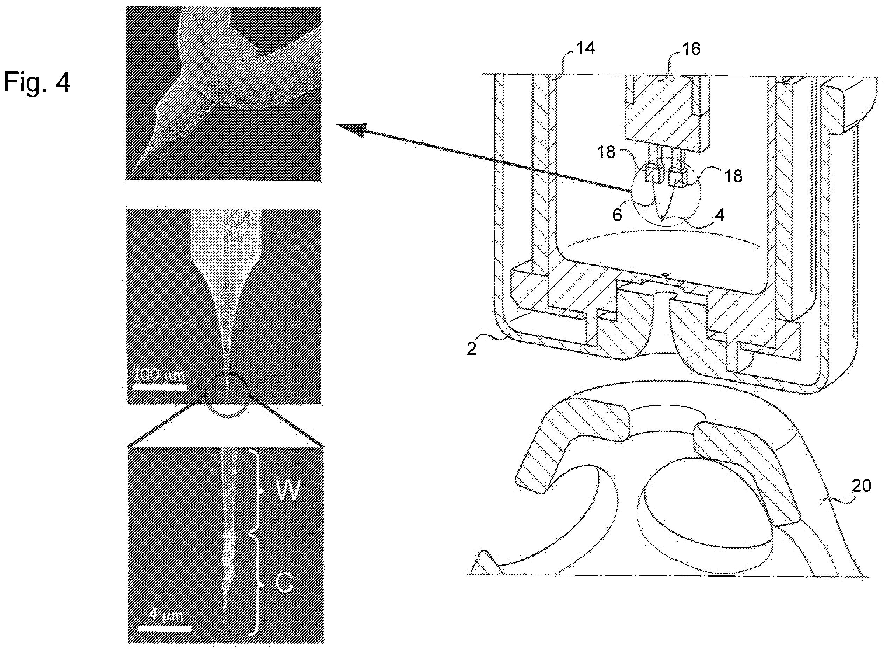

La figure 4 illustre une forme de réalisation d'un tel canon à électrons. Une enceinte 14 reçoit le filament 6 et la pointe 4. Ce filament 6 en forme de U est porté par une cathode 16 qui présente deux bornes 18. Les extrémités libres du filament 6 (en forme de U) sont fixées chacune à une borne 18.

Comme mentionné précédemment, le filament 6 porte la pointe 4 formée par une base cylindrique dont une extrémité est usinée pour être pointue. La base cylindrique est fixée sur le filament 6 à la base du U. Cette pointe 4 est par exemple réalisée en tungstène. La photo supérieure sur la figure 4 illustre la liaison entre la pointe 4, et plus précisément la base cylindrique de celle-ci, et le filament 6.

La pointe 4 est une pointe-support pour le cône décrit plus haut. La photo centrale de la figure 4 montre l'extrémité pointue de la pointe 4, qui est à l'opposé du filament 6. Sur cette image, à relativement grande échelle, on ne distingue pas clairement le cône qui devient bien visible sur la troisième photo à échelle agrandie (comme indiqué sur les photos). L'extrémité pointue de la pointe 4 porte ici le cône qui est rapporté par soudure. C'est à partir de ce cône que sont émis les électrons du canon à électrons décrit.

Pour extraire les électrons, on remarque que l'anode extractrice 2 est disposée sous un fond de l'enceinte 14. Le cône est placé de manière à faire face audit fond dans lequel est réalisé une petite ouverture. L'anode extractrice 2 vient en dessous du fond de l'enceinte 14, en entourant ladite petite ouverture. Les électrons sont extraits grâce à la différence de potentiel que l'on réalise entre l'anode extractrice 2 et la cathode 16.

Une fois les électrons extraits, ils se dirigent vers l'extérieur de l'enceinte 14, passent à travers l'anode extractrice 2 et passent par une anode de focalisation 20 (ou "focusing anode" en anglais). Cette anode de focalisation 20 présente ici une forme de cloche. Une ouverture en son sommet permet le passage des électrons. Des ouvertures sur sa paroi latérale sont prévues pour notamment permettre d'avoir le vide à l'intérieur de la cloche, au niveau du passage du faisceau d'électrons.

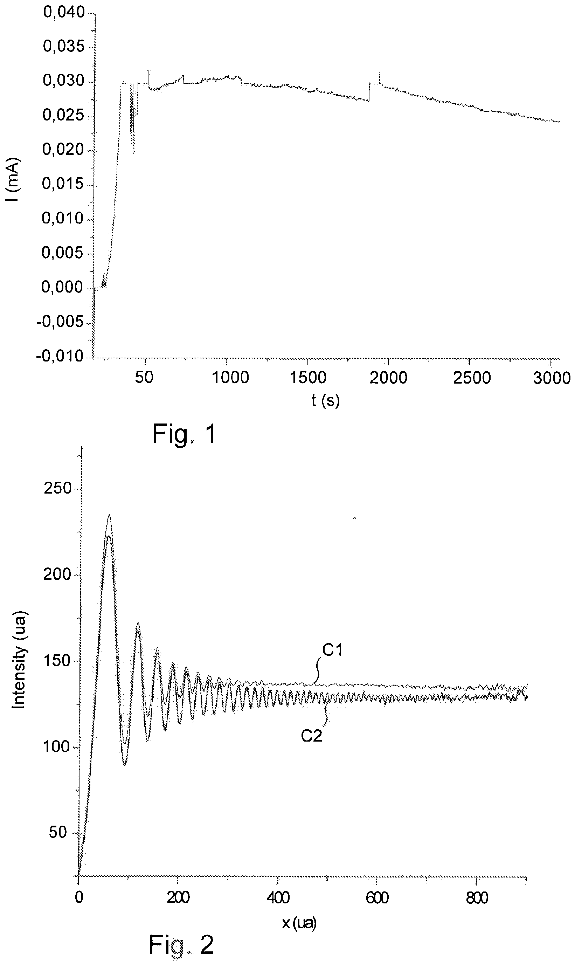

La figure 1 est un diagramme montrant l'intensité d'un faisceau d'électrons (en mA) en fonction du temps (en secondes). Ce diagramme montre que la variation de l'intensité, sur une heure, est inférieure à 16%.

La figure 2 illustre les bonnes performances de la cohérence spatiale du faisceau émis. Sur ce schéma, les performances en termes de cohérence spatiale d'un canon à électrons selon l'invention sont comparées à un canon à électrons présentant uniquement un filament de tungstène. La cohérence spatiale, comme illustrée sur cette figure 2, est au moins deux fois meilleure que celle obtenue avec un canon FEG à cathode froide de l'art antérieur. La courbe C1 sur cette figure représente une courbe obtenue avec un canon à électrons de l'art antérieur présentant une pointe tungstène uniquement et la courbe C2 est la courbe correspondante avec un canon à électrons de même type mais conforme à la présente invention.

Un canon à électrons selon la présente invention permet également d'obtenir une brillance réduite. Cette brillance est de 1,6 10⁻⁹ A m⁻² Sr⁻¹ V⁻¹, c'est-à-dire cinq fois plus qu'un canon FEG de l'art antérieur utilisant une pointe uniquement en tungstène.

Le facteur de champ évoqué plus haut (quotient F/V) avec un canon à électrons selon la présente invention a une valeur de 13000 mesuré sur un banc dédié et confirmé par holographie dans un microscope électronique en transmission.

Enfin, le faisceau d'électrons est stable sous une haute tension de 200 kV.

Du fait de la géométrie de l'ensemble pointe et cône, et du mode de soudure, l'ensemble ainsi obtenu est robuste et limite la vibration de la pointe. Comme écrit plus haut, on a également une forte brillance grâce à l'extrémité de la pointe en carbone (ou autre matériau tel carbone dopé au bore et/ou à l'azote). Le montage du cône sur une pointe tungstène permet également d'avoir une haute intensité grâce au courant fort supporté par ce montage. La qualité de la pointe émettrice et ses dimensions permettent d'obtenir une faible dispersion énergétique dans le faisceau d'électrons réalisé. Une grande cohérence spatiale peut également être obtenue grâce à la taille nanométrique de l'apex. La soudure entre le tungstène et le carbone telle que réalisée est une soudure stable qui garantit une excellente stabilité et une bonne durabilité sous ultravide du dispositif.

Toutes ces performances font qu'un canon à électrons selon la présente invention peut avantageusement être utilisé dans les domaines de la microscopie électronique, et notamment la microscopie électronique en transmission dans certains modes tels notamment la spectroscopie, l'holographie et l'holographie en champ sombre.

En complément, on peut rajouter que dans le domaine des sources d'électrons à cathode froide dédiées pour une utilisation intensive en microscopie électronique, Niels de Jonge *et al,* ont réalisé une avancée majeure en insistant sur les avantages du carbone, et notamment des nanotubes multi-parois, en tant que pointe émettrice (N. de Jonge et al Nature 420 (2002) 393-395 ; N de Jonge et al APL 85(9) 1607-1609 (2004) ; N de Jonge, N.J. van Druten Ultramicroscopy 95 (2003) 85-91 ; N de Jonge et al APL 87, 133118 p87 (2005) ; N de Jonge et al PRL 94, 186807 p1 (2005) ; N de Jonge et al Nano Letters 3, 1621-1624, (2003) ; C.J.Edgecombe et N de Jonge al J. Vac. Sci. Technol. B B 24(2) 869-873 (2006)). Malheureusement, énormément de problèmes techniques liés essentiellement à la tenue en tension, la stabilité mécanique, contact électrique du nanotube avec le filament, ... ne permettent pas de transférer cette technologie dans le marché des microscopes électroniques à balayage, microscopes électroniques en transmission, lithographie électronique ou autres (N. de Jonge et al Nature 420 (2002) 393-395 ; N de Jonge et al APL 85(9) 1607-1609 (2004) ; N de Jonge, N.J. van Druten Ultramicroscopy 95 (2003) 85-91 ; N de Jonge et al APL 87, 133118 p87 (2005) ; N de Jonge et al PRL 94, 186807 p1 (2005) ; N de Jonge et al Nano Letters 3, 1621-1624, (2003) ; C.J.Edgecombe et N de Jonge al J. Vac. Sci. Technol. B B 24(2) 869-873 (2006)). C'est dans ce contexte, que l'invention prend toute sa valeur. En effet, l'utilisation de cônes, notamment cônes de carbone, permet non seulement de garder les avantages associés aux matériaux, tout en améliorant la rigidité mécanique, la tenue en haute tension (lié à la structure en cône) ainsi que l'excellent contact électrique provenant à la fois de l'importante surface de liaison entre l'embase du cône et le filament conducteur, notamment de tungstène, mais aussi de la soudure ionique FIB de bien meilleure qualité que celle employée par de Jonge et ses collaborateurs. En utilisant cette nouvelle technologie, il suffit de seulement deux heures de travail pour transformer un canon froid tungstène classique en une source carbone (ou autre) décrite ci-dessus augmentant ainsi considérablement ses propriétés de brillance, cohérence et stabilité en courant comme décrit ci-dessus, le vide pouvant rester inchangé.

La présente invention ne se limite pas aux formes de réalisation décrites ci-dessus et aux variantes évoquées. Elle concerne également toutes les variantes de réalisation à la portée de l'homme du métier dans le cadre des revendications ci-après.

Ainsi, on ne sortirait pas du cadre de la présente invention par exemple si un élément était interposé entre le filament-pointe-en tungstène et la pointe émettrice en carbone (ou autre matériau). On peut songer notamment à l'interposition ici d'un filtre à spins qui permettrait ici d'obtenir un faisceau d'électrons polarisé et en spin.

## Revendications

1. Canon à électrons à émission de champ comportant une pointe (4) d'émission d'électrons supportée, une anode extractrice (2), ainsi que des moyens permettant de créer une différence de potentiel électrique entre la pointe d'émission et l'anode extractrice (2),
la pointe (4) d'émission comportant une seule pointe-support conductrice et un seul cône d'extrémité ayant une embase, obtenu par dépôt chimique en phase vapeur sur un nanofilament, la matière du cône d'extrémité étant choisie dans l'ensemble des matériaux comprenant le carbone et les matériaux carbonés décrits ou représentés par la formule CₓB_{y}N_{z}, C correspondant au carbone, B au bore et N à l'azote,
**caractérisée en ce que** le cône d'extrémité est aligné et soudé par son embase sur la pointe-support conductrice.

2. Canon à électrons selon la revendication 1, **caractérisé en ce que** le nanofilament est un nanofilament dont la matière est choisie dans l'ensemble des matériaux comprenant le carbone, les matériaux décrits ou représentés par la formule CₓB_{y}N_{z}, C correspondant au carbone, B au bore et N à l'azote, et les matériaux décrits ou représentés par la formule SiₓO_{y}, Si correspondant au silicium et O à l'oxygène.

3. Canon à électrons selon l'une des revendications 1 à 2, **caractérisé en ce que** le nanofilament est un nanotube en carbone dont le diamètre est inférieur à 20 nm (1 nm = 10⁻⁹m).

4. Canon à électrons selon l'une des revendications 1 à 3, **caractérisé en ce que** la pointe-support conductrice est une pointe métallique, notamment en tungstène.

5. Canon à électrons selon l'une des revendications 1 à 4, **caractérisé en ce que** la pointe-support (4) est supportée par un filament métallique (6) en tungstène.

6. Canon à électrons selon l'une des revendications 1 à 5, **caractérisé en ce que** le cône d'extrémité a une longueur comprise entre 0,5 et 10 µm (1 µm = 10-⁶ m).

7. Canon à électrons selon l'une des revendications 1 à 6, **caractérisé en ce que** la pointe d'émission et l'anode extractrice sont disposées dans une enceinte dans laquelle un vide poussé est réalisé à l'aide notamment d'une pompe utilisant du getter non évaporable.

8. Microscope électronique comportant un canon à électrons ainsi qu'une colonne contenant divers éléments tels des composants d'optique électronique et des moyens d'accélération des électrons émis par le canon à électrons, **caractérisé en ce que** le canon à électrons est un canon à électrons selon l'une des revendications 1 à 7.

9. Microscope selon la revendication 8, **caractérisé en ce que** les moyens d'accélération comportent des moyens permettant de créer une différence de potentiel électrique de 200 kV ou moins.

10. Dispositif d'irradiation électronique localisée, tel notamment un dispositif de nanogravure ou de nanolithographie, **caractérisé en ce qu'**il comporte un ou plusieurs canon(s) à électrons selon l'une des revendications 1 à 7.

11. Procédé de fabrication d'un canon à électrons à émission de champ comportant une pointe (4) d'émission d'électrons supportée, une anode extractrice (2), ainsi que des moyens permettant de créer une différence de potentiel électrique entre la pointe d'émission et l'anode extractrice (2),
on forme la pointe (4) d'émission à l'aide d'une seule pointe-support conductrice et d'un seul cône d'extrémité ayant une embase, en fabricant le cône d'extrémité par dépôt chimique en phase vapeur sur un nanofilament, la matière du cône d'extrémité étant choisie dans l'ensemble des matériaux comprenant le carbone et les matériaux carbonés décrits ou représentés par la formule CₓB_{y}N_{z}, C correspondant au carbone, B au bore et N à l'azote,
caractérisé en alignant et en soudant ledit cône par son embase sur la pointe-support conductrice.

12. Procédé selon la revendication 11, **caractérisé en ce que** l'on soude le cône d'extrémité sur ladite pointe-support à l'aide d'un faisceau d'ions métalliques générés par un appareillage, dit appareillage FIB, à faisceau d'ions focalisés, équipé d'un nanomanipulateur et d'un système à injection de gaz, dit système GIS.

13. Procédé selon la revendication 12, **caractérisé en ce qu'**on utilise une pointe-support conductrice en tungstène, ainsi qu'un appareillage FIB apte à générer des ions de tungstène et un système GIS apte à injecter du tungstène gazeux.

## Patentansprüche

1. Feldemissions-Elektronenkanone, die eine gehaltene Elektronenemissionsspitze (4), eine Extraktionsanode (2) sowie Mittel umfasst, mit denen eine elektrische Potentialdifferenz zwischen der Emissionsspitze und der Extraktionsanode (2) erzeugt werden kann,
wobei die Emissionsspitze (4) einen einzigen leitenden Spitzenhalter und einen einzigen Endkonus mit einer Basis umfasst, erhalten durch chemische Dampfphasenabscheidung auf ein Nanofilament, wobei das Material des Endkonus ausgewählt ist aus der Gruppe von Materialien, die Kohlenstoff und die durch die Formel CₓB_{y}N_{z} repräsentierten oder beschriebenen kohlenstoffhaltigen Verbindungen umfasst, wobei C Kohlenstoff entspricht, B Bor entspricht und N Stickstoff entspricht, **dadurch gekennzeichnet, dass** der Endkonus durch seine Basis mit dem leitenden Spitzenhalter ausgerichtet und verschweißt ist.

2. Elektronenkanone nach Anspruch 1, **dadurch gekennzeichnet, dass** das Nanofilament ein Nanofilament ist, dessen Material ausgewählt ist aus der Gruppe von Materialien umfassend Kohlenstoff, die durch die Formel CₓB_{y}N_{z} beschriebenen oder dargestellten Materialien, wobei C Kohlenstoff entspricht, B Bor entspricht und N Stickstoff entspricht, und die durch die Formel SiₓO_{y} beschriebenen oder dargestellten Materialien, wobei Si Silicium entspricht und O Sauerstoff entspricht.

3. Elektronenkanone nach einem der Ansprüche 1 bis 2, **dadurch gekennzeichnet, dass** das Nanofilament ein Nanoröhrchen aus Kohlenstoff ist, dessen Durchmesser kleiner als 20 nm (1 nm = 10⁻⁹ m) ist.

4. Elektronenkanone nach einem der Ansprüche 1 bis 3, **dadurch gekennzeichnet, dass** der leitende Spitzenhalter eine metallische Spitze insbesondere aus Wolfram ist.

5. Elektronenkanone nach einem der Ansprüche 1 bis 4, **dadurch gekennzeichnet, dass** der Spitzenhalter (4) von einem metallischen Filament (6) aus Wolfram gehalten wird.

6. Elektronenkanone nach einem der Ansprüche 1 bis 5, **dadurch gekennzeichnet, dass** der Endkonus eine Länge zwischen 0,5 und 10 µm (1 µm = 10⁻⁶ m) hat.

7. Elektronenkanone nach einem der Ansprüche 1 bis 6, **dadurch gekennzeichnet, dass** die Emissionsspitze und die Extraktionsanode in einem Gehäuse angeordnet sind, in dem ein Unterdruck insbesondere mittels einer Pumpe erzeugt wird, die nichtverdampfbares Getter benutzt.

8. Elektronenmikroskop, das eine Elektronenkanone sowie eine Säule umfasst, die diverse Elemente wie elektronische Optikkomponenten und Mittel zum Beschleunigen der von der Elektronenkanone emittierten Elektronen umfasst, **dadurch gekennzeichnet, dass** die Elektronenkanone eine Elektronenkanone nach einem der Ansprüche 1 bis 7 ist.

9. Mikroskop nach Anspruch 8, **dadurch gekennzeichnet, dass** die Beschleunigungsmittel Mittel umfassen, mit denen eine elektrische Potentialdifferenz von 200 kV oder weniger erzeugt werden kann.

10. Lokalisierte elektronische Strahlungsvorrichtung wie insbesondere eine Nanoätz- oder Nanolithografievorrichtung, **dadurch gekennzeichnet, dass** sie eine oder mehrere Elektronenkanonen nach einem der Ansprüche 1 bis 7 umfasst.

11. Verfahren zur Herstellung einer Feldemissions-Elektronenkanone, die eine gehaltene Elektronenemissionsspitze (4), eine Extraktionsanode (2) sowie Mittel umfasst, mit denen eine elektrische Potentialdifferenz zwischen der Emissionsspitze und der Extraktionsanode (2) erzeugt werden kann,
Bilden der Emissionsspitze (4) mit Hilfe eines einzigen leitenden Spitzenhalters und eines einzigen Endkonus mit einer Basis, durch Herstellen des Endkonus durch chemische Dampfphasenabscheidung auf ein Nanofilament, wobei das Material des Endkonus ausgewählt wird aus der Gruppe von Materialien, die Kohlenstoff und durch die Formel CₓB_{y}N_{z} beschriebene oder dargestellte kohlenstoffhaltige Materialien umfasst, wobei C Kohlenstoff entspricht, B Bor entspricht und N Stickstoff entspricht, **dadurch gekennzeichnet, dass** der Konus durch seine Basis mit dem leitenden Spitzenhalter ausgerichtet und verschweißt wird.

12. Verfahren nach Anspruch 11, **dadurch gekennzeichnet, dass** der Endkonus mit einem metallischen Ionenstrahl auf den Spitzenhalter geschweißt wird, erzeugt durch eine Apparatur, FIB-Apparatur genannt, mit fokalisierten Ionenstrahlen, ausgestattet mit einem Nanomanipulator und einem Gasinjektionssystem, GIS-System genannt.

13. Verfahren nach Anspruch 12, **dadurch gekennzeichnet, dass** ein leitender Spitzenhalter aus Wolfram sowie eine FIB-Apparatur, die Wolframionen erzeugen kann, und ein GIS-System benutzt werden, das gasförmiges Wolfram injizieren kann.

## Claims

1. Electron gun having field emission comprising a supported head (4) for electron emission, an extraction anode (2), and means which enable an electrical potential difference to be produced between the emission head and the extraction anode (2),
the emission head (4) comprising a single conductive support head and a single end cone having a base, obtained by means of chemical vapour deposition on a nanofilament, the material of the end cone being selected from all the materials comprising carbon and carbon-containing materials described or represented by the formula CₓB_{y}N_{z}, C corresponding to carbon, B to boron and N to nitrogen,
**characterised in that** the end cone is aligned and welded via the base thereof to the conductive support head.

2. Electron gun according to claim 1, **characterised in that** the nanofilament is a nanofilament whose material is selected from all the materials comprising carbon, the materials described or represented by the formula CₓB_{y}N_{z}, C corresponding to carbon, B to boron and N to nitrogen, and the materials described or represented by the formula SiₓO_{y}, Si corresponding to silicon and O to oxygen.

3. Electron gun according to either claim 1 or claim 2, **characterised in that** the nanofilament is a nanotube of carbon whose diameter is less than 20 nm (1 nm = 10⁻⁹ m).

4. Electron gun according to any one of claims 1 to 3, **characterised in that** the conductive support head is a metal head, in particular of tungsten.

5. Electron gun according to any one of claims 1 to 4, **characterised in that** the support head (4) is supported by a metal filament (6) of tungsten.

6. Electron gun according to any one of claims 1 to 5, **characterised in that** the end cone has a length between 0.5 and 10 µm (1 µm = 10⁻⁶ m).

7. Electron gun according to any one of claims 1 to 6, **characterised in that** the emission head and the extraction anode are arranged in a chamber in which a high vacuum is produced, in particular using a pump which uses non-evaporable getter.

8. Electron microscope comprising an electron gun and a column which contains various elements such as electronic optical components and means for accelerating the electrons transmitted by the electron gun, **characterised in that** the electron gun is an electron gun according to any one of claims 1 to 7.

9. Microscope according to claim 8, **characterised in that** the acceleration means comprise means which enable an electrical potential difference of 200 kV or less to be produced.

10. Device for localised electron irradiation, such as in particular a nanoengraving or nanolithography device, **characterised in that** it comprises one or more electron gun(s) according to any one of claims 1 to 7.

11. Method for producing an electron gun having field emission comprising a supported head (4) for electron emission, an extraction anode (2), and means which enable an electrical potential difference to be produced between the emission head and the extraction anode (2),
the emission head (4) is formed using a single conductive support head and a single end cone which has a base, the end cone being produced by means of chemical vapour deposition on a nanofilament, the material of the end cone being selected from all the materials comprising carbon and carbon-containing materials described or represented by the formula CₓB_{y}N_{z}, C corresponding to carbon, B to boron and N to nitrogen, **characterised by** aligning and welding the cone via the base thereof to the conductive support head.

12. Method according to claim 11, **characterised in that** the end cone is welded to the support head using a beam of metal ions generated by a device, referred to as the FIB device, having a beam of focused ions, provided with a nanomanipulator and a gas injection system, referred to as a GIS system.

13. Method according to claim 12, **characterised in that** a conductive support head of tungsten is used, and an FIB device which is capable of generating tungsten ions and a GIS system which is capable of injecting gaseous tungsten.
